# EUROPEAN PATENT APPLICATION

(11) **EP 2 743 369 A1**
(43) Date of publication of application: **18.06.2014**
(21) Application number: 12196541.2
(22) Date of filing: 11.12.2012
(51) Int. Cl.: C23C 10/02, C23C 10/52, C23C 10/54, C23C 10/56, C23C 10/60, C23C 28/02

(54) **Coating system, method of coating a substrate, and gas turbine component**

(71) Applicant: Siemens Aktiengesellschaft, 80333 München (DE)
(72) Inventor: Walker, Paul Mathew, Dunholme, Lincoln, LN2 3NE (GB)

(57) **Abstract**

A coating system for a superalloy substrate (25) is provided. The coating system comprises an inner coating layer (27), an intermediate coating layer (29) and an outer coating layer (31). The inner coating layer (27) is an aluminide layer, the intermediate coating layer (29) is a diffusion layer comprising Cr, Al, Ni and Co, where the Cr-content is between 15% by weight and 30% by weight, and the outer coating layer (31) is a Cr-free diffusion layer comprising Al and Ni, where the Al-content is between 15% by weight and 30% by weight.

## Description

The present invention relates to a coating system for a superalloy substrate, in particular a nickel-based, cobalt-based or iron-based substrate as well as to a method of coating a superalloy substrate. In addition, the invention relates to a gas turbine component, in particular to a nickel-based, cobalt-based or iron-based superalloy turbine component, with a coating system.

Due to the harsh environment generated by hot and corrosive combustion gases used as working fluid of gas turbines the components of gas turbines are subject to oxidation and/or corrosion. To increase corrosion resistance at the temperatures experienced by the gas turbine components these components are often coated with a corrosion resistant and/or oxidation resistant coating. Typical coating systems comprise aluminide coatings and so-called MCrAlY-coatings where M stands for nickel (Ni), cobalt (Co) or iron (Fe), Cr stands for chromium, Al stands for aluminium and Y stands for yttrium, hafnium or a rare earth element. Aluminide coatings or MCrAlY-coatings are often used as bond coats which are overlaid by a ceramic top coat as a thermal barrier coating. By this measures the corrosion and/or oxidation resistance of gas turbine components made of a superalloy, like for example gas turbine blades and vanes, can be further increased.

Some coating systems comprise multiple layers, for example multiple MCrAlY-layers, which may differ in their properties. WO 99/43861 A1 describes a multilayer bond coat for a thermal barrier coating system that comprises two bond coat layers which differ from each other in their surface roughness. A layer system in which different sublayers are formed by use of powder particles having different grain size distributions is described in US 2008/0160269 A1.

It is an objective of the present invention to provide an improved coating system and an improved method of coating a substrate. It is a further objective of the present invention to provide a gas turbine component with an advantageous coating system.

The first objective is achieved by a coating system as claimed in claim 1 and by a method of coating a substrate as claimed in claim 9. The second objective is achieved by a gas turbine component as claimed in claim 7. The depending claims contain further developments of the invention.

An inventive coating system for a superalloy substrate, in particular for a nickel-based, cobalt-based or iron-based superalloy substrate, comprises an inner coating layer, an intermediate coating layer and an outer coating layer. The inner coating layer is an aluminide layer, the intermediate layer is a diffusion layer comprising Cr, Al, Ni and/or Co, where the Cr-content is between 15% by weight and 30% by weight. The outer layer is a substantially Cr-free diffusion layer comprising Al and Ni, where the Al-content is between 15% by weight and 30% by weight.

The inventive coating system is based on the insight that corrosion attacks components, for example gas turbine components at two distinct temperatures, at two distinct temperature ranges, known as type I corrosion occurring at temperatures in the range of 800°C to 950°C and type II corrosion occurring at temperatures in the rage of 670°C to 750°C. Different materials and coatings react better in one type of corrosion than the other. This is, in particular, true for gas turbine components both of the rotor and the stator. However, this is also true for other components which are used in applications in which they are subject to corrosion over the full range of temperature from 670°C to 950°C.

In the inventive coating system the inner aluminide layer serves as a final line of protection for the underlying superalloy substrate. The intermediate layer, which has a high chromium content, serves as protective layer against type II corrosion, and the outer coating layer, which has a high aluminium content, serves as a protection layer to protect against type I corrosion. In other words, the inventive coating system includes a specialized layer to protect against type I corrosion and a specialized layer to protect against type II corrosion. Therefore, the component is well protected against corrosion and/or oxidation over the full range of temperatures from 670°C to 950°C.

An particularly effective protection against type II corrosion can be achieved if the chromium content of the intermediate layer is in the range of 18% by weight to 22% by weight. Likewise, a particularly effective protection against type I corrosion can be achieved if the aluminium content of the outer layer is between 18% by weight and 22% by weight. Therefore, in an advantageous development of the inventive coating system the intermediate layer has a chromium content in the ranger of 18% by weight to 22% by weight. Additionally or alternatively, the outer coating layer has an aluminium content in the range of 18% by weight to 22% by weight in this development.

Moreover, it is advantageous if the aluminium content of the intermediate layer is smaller than the aluminium content of the outer layer. In particular, the aluminium content of the intermediate layer may be in the range of 4% by weight to 12% by weight. Additionally or alternatively, the cobalt content of the intermediate layer may in the range of 5 % by weight to 15% by weight.

According to a further development of the inventive coating system the intermediate coating layer comprises up to 1% by weight yttrium (Y) and/or up to 2% by weight silicon (Si) and/or up to 1% by weight hafnium (Hf). Additionally or alternatively, the outer coating layer comprises up to 1% by weight yttrium and/or up to 2% by weight silicon and/or up to 1% by weight hafnium. Silicon, hafnium and yttrium contribute to stabilizing the oxide formed during a corrosive attack and therefore slow down the attack further.

A typical composition that may be used as intermediate coating layer comprises by weight:
8% to 12% Co,
18% to 22% Cr,
8% to 12% Al,
0% to 2% Si,
0% to 1% Y,
0% to 1% Hf, and
rest Ni.

A typical outer coating layer may comprise by weight:
18% to 22% Al,
0% to 2% Si,
0% to 1% Y,
0% to 1% Hf, and
rest Ni.

An inventive gas turbine component, which may in particular be a gas turbine blade or vane, comprises a surface and an inventive coating system on the surface in order to increase the oxidation and/or corrosion resistance according to the mechanisms described with respect to the inventive coating system. Moreover, in a further development, the surface underlying the coating system may be chromised or platisined.

The inventive method of coating a substrate with the coating system comprises the steps of:
- aluminising the surface of the substrate to form an inner coating layer;
- applying a slurry with a solid content comprising Cr, Al, Ni and Co onto the inner coating layer, where the Cr-content of the solid content is in the range of 15% by weight to 30% by weight, and diffusion heat treating the slurry applied to the inner coating layer at a temperature above 800 °C for 1 to 8 hours to form an intermediate coating layer; and
- applying a substantially Cr-free slurry with a solid content comprising Al and Ni onto the intermediate coating layer, where the Al-content of the solid content is in the range of 15% by weight to 30% by weight, and diffusion heat treating the slurry applied onto the intermediate surface layer at a temperature above 800 °C for 1 to 8 hours to form an outer coating layer.

With the inventive method a coating system with the properties of the above-mentioned inventive coating system can be produced.

In the context of the inventive method it is advantageous if the slurry applied onto the inner coating layer and/or the slurry applied onto the intermediate coating layer is/are diffusion heat treated at a temperature above 850 °C.

Likewise, it is advantageous if the slurry applied onto the inner coating layer and/or the slurry applied onto the intermediate coating layer is/are diffusion heat treated for 2 to 4 hours.

In the inventive method, the surface of the substrate may be platinised before it is aluminised. Platinising the surface may be done by platinum plating the surface and heat-treating the platinum plated surface.

Additionally or alternatively, the surface of the substrate may be chromised before it is platinised. Chromising may be done also on internal surfaces of the substrate.

In the inventive method the slurry applied onto the inner coating layer may comprises an ethanol carrier or an acid based carrier. Likewise, the slurry applied onto the intermediate coating layer may comprise an ethanol carrier or an acid based carrier.

Further features, properties and advantages will become clear from the following description of embodiments in conjunction with the accompanying drawings.
Figure 1 schematically shows a gas turbine rotor blade.
Figure 2 schematically shows a gas turbine stator vane.
Figure 3 schematically shows the inventive coating system.
Figure 4 shows a flow diagram of the inventive method.
Figure 5 shows a flow diagram of a pre-treatment of a gas turbine component prior to applying the inventive coating system.
Figure 6 shows a modification of the coating system shown in Figure 3.

Typical gas turbine components to which the inventive coating system may be applied are turbine vanes and blades in particular those surfaces of turbine vanes and blades which come into contact with the hot and corrosive working fluid of a gas turbine.

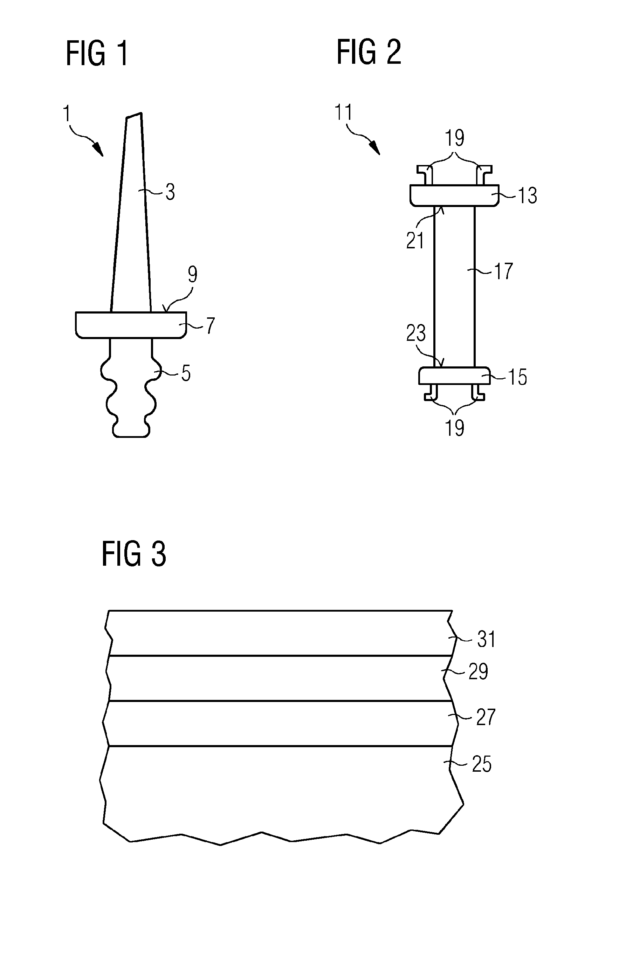

A typical rotor blade is schematically shown in Figure 1, whereas typical stator vane is schematically shown in Figure 2.

A typical rotor gas turbine rotor blade comprises an airfoil section 3, a root section 5 and a platform 7 located between the airfoil section 3 and the root section 5. The rotor blade is fixed to a rotor shaft (not shown) by means of the root section 5 which has a special shape that is adapted to the shape of a notch in the rotor shaft. In the present illustration, a so-called dovetail root is shown.

Those parts of the turbine blade coming into contact with hot and corrosive combustion gases, which form the working medium of a gas turbine, are the surface of the airfoil section 3 and the radial outer surface 9 of the platform 7. Hence, at least the surface of the airfoil section 3 and typically also the radial outer surface 9 of the platform 7 are equipped with an oxidation and/or corrosion resistive coating which will be described later with respect to Figure 3.

Figure 2 schematically shows a typical stator vane 11 of a gas turbine. The stator vane 11 comprises a radial outer platform 13, a radial inner platform 15, and an airfoil section 17 extending between the radial outer platform 13 and the radial inner platform 15. On their sides showing away from the airfoil section 17 the platforms 13, 15 are equipped with fixing structures for fixing the turbine vane to a housing or a stator ring. These fixing structures are implemented as hook-like structures 19 in the present embodiment. However, other structures for fixing stator vanes are known to those skilled in the art. The hook-like structures 19 are therefore only shown as an non-exclusive example for a typical fixing structure.

Those surfaces of the stator vane which come into contact with the hot and corrosive combustion gases of a gas turbine are the surfaces of the airfoil section 7, the radial inner surface 21 of the radial outer platform 13 and the radial outer surface 23 of the radial inner platform 15. All of these surfaces, or at least some of them, are, therefore, equipped with an oxidation and/or corrosion resistive coating system. The coating system will be described next with respect to Figure 3.

The structure of the oxidation and/or corrosion resistive coating system of the present invention is schematically shown in Figure 3. The Figure shows a substrate 25 which is made of a high temperature resistive superalloy, typically a nickel-based superalloy or a cobalt-based superalloy. However, also iron-based superalloys may be used. In the present embodiment, the substrate is a nickel-based superalloy. The substrate 25 may represent a gas turbine component, for example a gas turbine blade or vane.

On the surface of the nickel-based superalloy 25 a nickel aluminide layer 27 is present which forms an inner coating layer of the coating system.

On the surface of the nickel aluminide layer 27, a first diffusion layer 29 having a high chromium content is present. This layer, which forms an intermediate coating layer of the coating system, typically comprises chromium (Cr), aluminium (Al), nickel (Ni) and cobalt (Co), where the chromium content is between 15% by weight and 30% by weight, preferably between 18% by weight and 22% by weight. Moreover, the aluminium content of the first diffusion layer 29 is below 15%, preferably between 4% by weight and 12% by weight. In addition, the cobalt content is between 5% by weight and 15% by weight.

On top of the first diffusion layer 29 a second diffusion layer 31 with a high aluminium content is present. The second diffusion layer 31 forms the outer coating layer of the coating system. The outer layer 31 is substantially chromium-free and comprises aluminium (Al) and nickel (Ni), where the aluminium content is between 15% by weight and 30% by weight, in particular between 18% by weight and 22% by weight.

The chromium-rich intermediate layer 29 forms a protective layer for protection against type II corrosion whereas the outer layer forms a protective layer against type I corrosion. The corrosion protection is provided by an oxide scale formed during oxidative and/or corrosive attack, which oxide scale slows down the oxidation and/or corrosion process. To stabilize the oxide scale, and thereby slowing the oxidation and/or corrosion attack further, at least one of the elements silicon (Si), hafnium (Hf) and yttrium (Y) may be added to the intermediate layer 29 and/or to the outer layer 31. Please note that also combinations of two of the elements silicon, hafnium and yttrium may be added, or even all three elements. When adding silicon to the intermediate coating layer and/or to the outer coating layer 31 the amount of silicon may be up to 2% by weight. When hafnium or yttrium is added to the intermediate coating layer 29 and/or to the outer coating layer 31 the amount of the respective element may be up to 1% by weight.

An example for a typical composition of the intermediate coating layer is (in percent by weight) 20% chromium, 10% cobalt, 10% aluminium, up to 2% silicon, up to 1% yttrium, and up to 1% hafnium, rest nickel. An example for a typical composition of the outer coating layer is (in percent by weight) 20% aluminium, up to 2% silicon, up to 1% yttrium, and up to 1% hafnium, rest nickel.

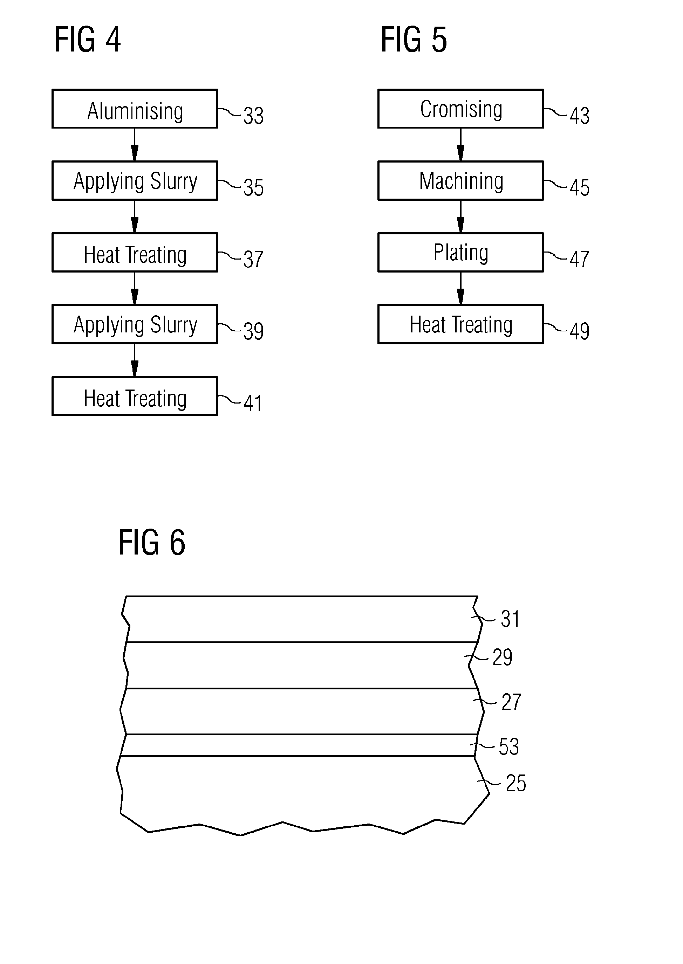

A method of producing the coating system that has been described with respect to Figure 3 will be described in conjunction with the flow diagram of Figure 4.

In a first step 33 of the coating process the surface 25 of the substrate is aluminised. Aluminising can be done by a chemical vapour deposition process (CVD) or by a pack aluminising process. The aluminising process leads to an aluminide layer, i.e. the nickel aluminide layer 27 forming the inner coating layer in Figure 3.

In a next step 35, a slurry with an ethanol carrier and a solid content is applied onto the surface of the aluminide layer. The solid content of the slurry comprises chromium (Cr), aluminium (Al), nickel (Ni), and cobalt (Co), where the chromium content of the solid content is between 15% and 30% by weight of the solid content, in particular between 18% and 22% by weight of the solid content. In addition, the solid content may contain up to one percent by weight hafnium (Hf) and/or up to 1% by weight yttrium (Y) and/or up to 2% by weight silicon (Si).

In step 37, a diffusion heat treatment follows on the application of the slurry. The diffusion heat treatment is performed at temperatures above 800 °C for 1 to 8 hours, preferably for 2 to 4 hours. In particular, the temperatures used in the diffusion heat treatment may be above 850°C, preferably 870°C. The diffusion heat treatment leads to the formation of the intermediate coating layer 29 in Figure 3.

After forming the intermediate coating layer 29, a further slurry is supplied in step 39 onto the surface of the intermediate coating layer 29. The slurry includes an ethanol carrier and a solid content. The solid content comprises nickel (Ni) and aluminium (Al) and is substantially free of chromium. The aluminium content of the solid content is between 15% and 30% by weight of the solid content, in particular between 18% and 22% by weight of the solid content. Moreover, silicon (Si) could be present in the solid content up to 2% by weight of the solid content and/or hafnium (Hf) could be present in the solid content up to 1% by weight of the solid content and/or yttrium (Y) could be present in the solid content up to 1% by weight of the solid content. After the slurry has been applied onto the surface of the intermediate coating layer 29 a heat treatment is performed with a temperature above 800°C, in particular above 850°C, for 1 to 8 hours, in particular for 2 to 4 hours. A typical temperature of the heat treatment may be 870 °C. By this diffusion heat treatment of step 41 the outer coating layer 31 of the coating system shown in Figure 3 is formed.

Although the method described with respect to Figure 4 is sufficient for forming the coating system described with respect to Figure 3 and optional pre-treatment of the substrate could be performed. The pre-treatment will be described with respect to Figure 5 which shows a flow diagram of the pre-treatment.

In a first step 43 of the pre-treatment the surface of the substrate 25 is chromised. In the chromising process the outer surface of the substrate 25 is chromised. In addition, the inner surface of the substrate 25, for example cooling channels of a turbine vane or blade, could be chromised as well.

After chromising the surface of the substrate 25 the chromised surface is machined in step 45.

In a next step 47 the machined surface is plated with platinum.

After plating the surface with platinum in step 47 a diffusion heat treatment is performed in step 49 for creating a diffusion zone in the substrate. With finishing the diffusion heat treatment of step 49 the pre-treatment is finished and the process of appaying the coating system can start.

A coating system which has been formed with the described pre-treatment is shown in Figure 6. Those layers which do not differ from layers of Figure 3 are denominated with the same reference numerals as in Figure 3 and will not be described again to avoid repetitions.

In the coating system shown in Figure 6 the nickel aluminide layer 51 which forms the inner coating layer of the coating system is modified with platinum and/or chromium as compared to the nickel aluminide layer 27 of Figure 3. Moreover, a diffusion zone 53 is formed at the interface between the modified nickel aluminide layer 51 and the substrate 25. The intermediate coating layer 29 and the outer coating layer 31 do not differ from the respective layers of Figure 3.

Please note that the chromising step together with the machining step are optional steps of the pre-treatment. Likewise, the platinum plating and the heat treatment are also optional steps of the pre-treatment. Therefore, in a modification of the pre-treatment the pre-treatment only includes the chromising step 43 and the machining step 45. In another modification of the pre-treatment the pre-treatment only includes the platinum plating step 47 and the heat treatment of step 49.

The present invention has been illustrated by reference to exemplary embodiments thereof. However, a person skilled in the art recognizes that he can depart from the specific embodiments described with respect to the Figures. For example, an acid based carrier could be used in the slurry for forming the intermediate coating layer and/or in the slurry for forming the outer coating layer instead of ethanol. Therefore, the specific embodiments are not meant to restrict the present invention. Instead, the scope of protection shall only be restricted by the appended claims.

## Claims

1. A coating system for a superalloy substrate (25), comprising an inner coating layer (27), an intermediate coating layer (29) and an outer coating layer (31),
wherein
- the inner coating layer (27) is an aluminide layer;
- the intermediate coating layer (29) is a diffusion layer comprising Cr, Al, Ni and Co, where the Cr-content is between 15% by weight and 30% by weight; and
- the outer coating layer (31) is a Cr-free diffusion layer comprising Al and Ni, where the Al-content is between 15% by weight and 30% by weight.

2. The coating system as claimed in claim 1, in which the Cr-content of the intermediate coating layer (29) is between 18% by weight and 22% by weight and/or in which the Al-content of the outer coating layer (31) is between 18% by weight and 22% by weight.

3. The coating system as claimed in claim 1 or claim 2, in which the Al-content of the intermediate coating layer (29) is between 4% by weight and 12% by weight and/or in which the Co-content of the intermediate coating layer (29) is between 5% by weight and 15% by weight.

4. The coating system as claimed in any of the preceding claims, in which the intermediate coating layer comprises (29) up to 1% by weight Y and/or up to 2% by weight Si and/or up to 1% by weight Hf, and/or in which the outer coating layer (31) comprises up to 1% by weight Y and/or up to 2% by weight Si and/or up to 1% by weight Hf.

5. The coating system as claimed in claim 4, in which the intermediate coating layer (29) comprises by weight:
8% to 12% Co,
18% to 22% Cr,
8% to 12% Al,
0% to 2% Si,
0% to 1% Y,
0% to 1% Hf,
rest Ni.

6. The coating system as claimed in claim 4 or claim 5, in which the outer coating layer (31) comprises by weight:
18% to 22% Al,
0% to 2% Si,
0% to 1% Y,
0% to 1% Hf,
rest Ni.

7. A gas turbine component comprising a surface and a coating system according to any of the preceding claims on the surface.

8. The gas turbine component as claimed in claim 7, in which the surface underlying the coating system is a chromised or platinised.

9. A method of coating a substrate with a coating system, comprising the steps of:
- aluminising the surface of the substrate (25) to form an inner coating layer (27);
- applying a slurry with a solid content comprising Cr, Al, Ni and Co onto the inner coating layer (27), where the Cr-content of the solid content is between 15% and 30% by weight of the solid content, and diffusion heat treating the slurry applied to the inner coating layer (27) at a temperature above 800°C for 1 to 8 hours to form an intermediate coating layer (29); and
- applying a Cr-free slurry with a solid content comprising Al and Ni onto the intermediate coating layer (29), where the Al-content of the solid content is between 15% and 30% by weight of the solid content, and diffusion heat treating the slurry applied onto the intermediate surface layer (29) at a temperature above 800°C for 1 to 8 hours to form an outer coating layer (31).

10. The method as claimed in claim 9, in which the slurry applied onto the inner coating layer (27) and/or the slurry applied onto the intermediate coating layer (29) is/are diffusion heat treated at a temperature above 850°C.

11. The method as claimed in claim 9 or claim 10, in which the slurry applied onto the inner coating layer (27) and/or the slurry applied onto the intermediate coating layer (29) is/are diffusion heat treated for 2 to 4 hours.

12. The method as claimed in any of the claims 9 to 11, in which the surface of the substrate (25) is platinised before it is aluminised.

13. The method as claimed in claim 12, in which the surface of the substrate (25) is platinised by platinum plating the surface and heat-treating the platinum plated surface.

14. The method as claimed in claim 12 or 13, in which the surface of the substrate (25) is chromised before it is platinised.

15. The method as claimed in any of the claims 9 to 14, in which the slurry applied onto the inner coating layer (27) comprises an ethanol carrier or an acid based carrier, and/or the slurry applied onto the intermediate coating layer (29) comprises an ethanol carrier or an acid based carrier.
